# EUROPÄISCHE PATENTANMELDUNG

(11) **EP 2 985 363 A1**
(43) Veröffentlichungstag der Anmeldung: **17.02.2016**
(21) Anmeldenummer: 14180899.8
(22) Anmeldetag: 13.08.2014
(51) Int. Cl.: C23C 14/16, C23C 14/02, B05D 5/06, B32B 15/00

(54) **Beschichtete Substrate**

(71) Anmelder: Koch, Matthias, 59969 Bromskirchen (DE)
(72) Erfinder: Koch, Matthias, 59969 Bromskirchen (DE)
(74) Vertreter: Metten, Karl-Heinz

(57) **Zusammenfassung**

Die Erfindung betrifft ein beschichtetes Substrat, umfassend a) ein Substrat mit einer be-schichtbaren Oberfläche, b) mindestens eine aufgedampfte oder aufgesputterte Metallschicht, c) mindestens eine Haftvermittlerschicht, gebildet aus einem oxidativ trocknenden oder oxidativ getrockneten Öl, und d) mindestens eine, insbesondere transparente oder transluzente, Decklackschicht.

## Beschreibung

Die vorliegende Erfindung betrifft beschichtete Substrate.

Viele metallische und nicht-metallische Bauteile werden bereits seit langem zur Erzeugung einer glatten und/oder glänzenden Oberfläche beschichtet. In der Regel handelt es sich hierbei um mehrlagige Beschichtungssysteme, die insbesondere auch dem Zweck dienen, metallische Bauteile korrosionsresistent auszustatten. Solange diese beschichteten Bauteile keine mechanische Beschädigung erfahren, kann Korrosionsbeständigkeit in der Regel über einen längeren Zeitraum aufrechterhalten werden. Vielfach setzt jedoch bereits bei geringfügigsten mechanischen Beschädigungen der beschichteten Oberfläche Korrosion ein, wodurch es zu einer starken optischen Beeinträchtigung der Oberfläche kommt. Hiermit geht nicht selten ein Abplatzen von Beschichtungsarealen einher.

Um beschichtete glänzende Oberflächen korrosionsbeständig auszustatten, hat es sich nicht an Versuchen gefehlt. Beispielsweise beschreibt die DE 123 765 A1 ein Verfahren zur Erzeugung einer Korrosionsschutzschicht auf einer metallischen Oberfläche, bei dem ein auf Siliziumverbindungen basierendes Sol, ein Aminoalkyl-funktionalisiertes Alkoxysilan oder ein Umsetzungsprodukt der beiden vorrangehend genannten Komponenten zum Einsatz kommt.

Gemäß der DE 38 33 119 C2 erhält man eine sehr gut auf einem Substrat haftende korrosionsgeschützte chromatierte Metalloberfläche dadurch, dass der Elektrotauchlack direkt auf die Chromatierschicht ohne Zwischentrocknung auf der Oberfläche abgeschieden wird. Korrosionsschutzbeschichtungen für Metallsubstrate zeigen jedoch noch stets erhebliches Verbesserungspotential in Sachen Haftung und Korrosionsschutz, insbesondere bei massengefertigten Produkten, vor allem solchen mit anspruchsvoller Geometrie.

Der vorliegenden Erfindung lag daher die Aufgabe zu Grunde, beschichtete Substrate zur Verfügung zu stellen, die nicht mehr mit den Nachteilen des Stands der Technik behaftetet sind und die insbesondere auch in der Massenfertigung beschichtete Produkte mit verbessertem Korrosionsschutz und sehr guten Haftungseigenschaften liefern. Es werden auch solche beschichteten Produkte angestrebt, die bei mechanischer Oberflächenbeschädigung nicht sogleich Unterwanderungsphänomene verbunden mit dem Abblättern von Schichten zeigen.

Demgemäß wurde ein beschichtetes Substrat gefunden, umfassend
a) ein Substrat mit einer beschichtbaren Oberfläche,
b) mindestens eine aufgedampfte oder aufgesputterte Metallschicht, insbesondere aufgebracht mittels Physical Vapour Deposition (PVD)-Beschichtung, Aufdampfen mittels eines Elektronenstahl-Verdampfers, Aufdampfen mittels eines Widerstandsverdampfers, Induktionsverdampfung, ARC-Verdampfung oder Kathoden- bzw. Anodenzerstäubung (Sputter-Beschichtung), jeweils vorzugsweise im Vakuum,
c) mindestens eine Haftvermittlerschicht, gebildet aus einem oxidativ trocknenden oder oxidativ getrockneten Öl, und
d) mindestens eine, insbesondere transparente oder transluzente, Deck- bzw. Decklackschicht.

Die genannten Schichten liegen insbesondere in der geschilderten Reihenfolge vor, wobei dieses nicht bedeutet, dass die aufeinander folgenden Schichten unmittelbar miteinander in Kontakt stehen müssen. Vielmehr können auch weitere Schichten dazwischen angeordnet sein, wie z.B. nachfolgend noch ausgeführt. Die mindestens eine Haftvermittterschicht gemäß c) liegt allerdings bevorzugt unmittelbar auf der aufgedampften oder aufgesputterten Metallschicht gemäß b) auf bzw. wird unmittelbar auf dieser angebracht. Auch liegt die Deckschicht gemäß d) bevorzugt unmittelbar auf der Haftvermittlerschicht gemäß c) auf bzw. wird unmittelbar auf dieser angebracht.

Besonders geeignete erfindungsgemäße beschichtete Substrate umfassen ferner, insbesondere unmittelbar auf der beschichtbaren Oberfläche des Substrats und/oder unterhalb der Metallschicht gemäß b):
e) mindestens eine erste und gegebenenfalls hierauf aufliegend mindestens eine zweite Grundierungsschicht.

Die erfindungsgemäßen beschichteten Substrate gehen vorzugsweise zurück auf Metallsubstrate sowie auf wie nicht-metallische Substrate wie Glas, Keramik, Verbundfasermaterialien, Karbonmaterialien oder Kunststoffe.

Besonders geeignete Materialien für Kunststoffsubstrate stellen z.B. PVC, Polyurethane, Polyacrylate, Polyester, z.B. PBT und PET, Polyolefine, insbesondere Polypropylen, Polycarbonate, Polyamide, Polyphenylenether, Polystyrol, Styrol(co)polymere, wie ABS, SAN, ASA oder MABS, Polyoxyalkylene, z.B. POM, und Teflon sowie Polymerblends wie ABS/PPE, ASA/PPE, SAN/PPE, und ABS/PC dar. In geeigneten Substraten können neben metallischen Komponenten oder Abschnitten auch nicht-metallische Komponenten bzw. Abschnitte vorliegen. Sollen Kunststoffsubstrate mit einer besonders glatten Oberfläche, insbesondere mit hoher Zuverlässigkeit, erhalten werden, trägt man zumeist mindestens eine Grundierungsschicht auf. Geeignete Grundierungsschichten für Kunststoffsubstrate stellen z.B. Klarlacke oder UV-Lacke dar. Kunststoffsubstrate im Sinne der vorliegenden Erfindung umfassen auch Kunststoffbeschichtungen. Auf Kunststoffsubstrate können Grundierungsmaterialien bevorzugt im Nasslackverfahren aufgetragen werden. Bei hoch hitzebeständigen Kunststoffen kommt ebenfalls das Pulverlackverfahren in Kraft.

Grundsätzlich eignen sich als metallische Substrate Formkörper bzw. Bauteile aus allen Metallen und Metalllegierungen. Als geeignete metallische Substrate seien exemplarisch solche aus Aluminium, Eisen, Stahl, Edelstahl, Kupfer, Messing, Magnesium, Iridium, Gold, Silber, Palladium, Platin, Ruthenium, Molybdän, Nickel, Bronze, Titan, Zink, Blei, Wolfram oder Mangan sowie deren Legierungen genannt. Bevorzugte Metallsubstrate bzw. Metallsubstratoberflächen umfassen bzw. insbesondere bestehen aus Aluminium oder Aluminiumlegierungen, Magnesium oder Magnesiumlegierungen oder Titan oder Titanlegierungen oder aus Stahl oder Edelstahl. Besonders bevorzugt wird für die metallischen Substrate auf Aluminium und Aluminiumlegierungen, Kupfer und Kupferlegierungen sowie auf Stahl zurückgegriffen. Auch Substrate aus Druckguss, z.B. Zinkdruckguss, sind besonders geeignet.

Stellt das Substrat ein Metallsubstrat dar, hat es sich regelmäßig als vorteilhaft erwiesen, insbesondere wenn dieses Metallsubstrat unmittelbar dem jeweiligen Fertigungsprozess entnommen ist, die Oberfläche des Substrats in geeigneter Weise zu reinigen. Beispielsweise kann in einem ersten vorbereitenden Schritt die Metallsubstratoberfläche mit alkalischen oder sauren Reagenzien entfettet werden. Kommerzielle Entfettungsschritte sind auch unter den Begriffen Abkoch- bzw. Beizentfetten bekannt. Alternativ kann eine Metalloberfläche in einem elektrolytischen Entfettungsbad anodisch entfettet werden.

Überdies hat es sich in manchen Fällen als zweckmäßig erwiesen, die Oberfläche des Metallsubstrats, insbesondere die entfettete Metallsubstratoberfläche, mindestens einem Dekapierschritt zu unterziehen. Für die Dekapierung der Metallsubstratoberfläche setzt man z.B. ein saures Spülbad ein. Eine geeignete Dekapierlösung stellt demgemäß z.B. verdünnte Salzsäure (1:10 vol/vol) dar. Im Ergebnis erhält man in der Regel eine im Wesentlichen oxidfreie Metalloberfläche. Ebenso wie der Entfettungsschritt wird auch der Dekapierschritt im Allgemeinen durch einen Spülschritt abgeschlossen.

Wird die Metallsubstratoberfläche poliert und/oder geschliffen bzw. gleitgeschliffen, kann häufig der Entfettungs- und/oder Dekapierschritt entfallen. Üblicherweise wird bei dieser Art der Oberflächenbearbeitung hinreichend Material von dieser Oberfläche abgetragen, womit dann auch auf der Oberfläche aufliegende bzw. anhaftende Verunreinigungen oder anderweitige Bestandteile mit entfernt werden. Wird die Oberfläche poliert bzw. geschliffen, kann überdies häufig auch auf die Auftragung einer ersten und gegebenenfalls zweiten Grundierschicht verzichtet werden. Mit dem Polieren bzw. Schleifen wird zumeist bereits eine derart ebene bzw. glatte Oberfläche erhalten, dass eine Einglättung durch Aufbringen einer Grundierschicht nicht mehr erforderlich ist. Allerdings kann es, wenn das Metallsubstrat zahlreiche Winkel und Ecken aufweist, die sich nicht ohne weiteres hinreichend polieren bzw. schleifen lassen, empfehlenswert sein, einen ersten und möglicherweise auch einen zweiten Grundierschritt nachzuschalten.

Glas- und Keramiksubstrate sind in der Regel bereits per se so glatt, dass es eines Polierschritts oder der Aufbringung zusätzlicher Grundierschichten nicht bedarf. Dieses trifft im Allgemeinen auch auf Kunststoffsubstrate zu.

Darüber hinaus kommen als geeignete Substrate für die erfindungsgemäßen beschichteten Substrate insbesondere auch KTL-beschichtete Substrate, ATL-beschichtete Substrate, eloxierte Substrate, verchromte Substrate, beispielsweise galvanisch verchromte Substrate, oder grundlackierte Substrate in Betracht. Mit der KTL- oder ATL-Beschichtung kann eine Farbbeschichtung oder eine transparente Beschichtung erzeugt werden. Für die Herstellung der KTL-Schicht greift man z.B. in einer Ausführungsform auf Epoxyharze, insbesondere kationische Epoxyharze zurück. Der Aushärtschritt bei der Herstellung der KTL- bzw. der ATL-Schicht geht vorzugsweise thermisch vonstatten, d.h. als Temperschritt. Alternativ kann der Aushärtschritt z.B. auch mit Hilfe von Katalysatoren chemisch aktiviert werden, wodurch der Aushärtschritt gegebenenfalls auch schon bei Raumtemperatur stattfinden kann. Verwendet man bei dem erfindungsgemäßen beschichteten Substrat eine KTL- oder ATL-Beschichtung hat es sich als vorteilhaft erwiesen, das Substrat zuvor einem Phosphatierschritt, insbesondere einer Eisen-und/oder Zinkphosphatierung, zu unterziehen.

Die erste und gegebenenfalls die zweite Grundierungsschicht können beispielsweise über ein Nasslackverfahren oder ein Pulverbeschichtungsverfahren aufgetragen werden. Geeignet sind zum Beispiel pulverförmige Polyesterharzverbindungen sowie Epoxid/Polyester-Pulver. Geeignete Epoxidharze als Grundierungsschichtmaterialien sind im Handel z.B. unter dem Markennamen "Valophene" bekannt. Als erste und zweite Grundierungsschichten kommen auch solche basierend auf einem Urethanharz, wie in der US 4,431,711 beschrieben, in Betracht. Alternativ kann ebenfalls auf Polyester- oder Polyacrylatmaterialien, wie in der WO 2004/014646 A1 hervorgehoben, zurückgegriffen werden. Ganz besonders bevorzugt wird zum Zweck der Grundierung auf Nasslackverfahren zurückgegriffen. Besonders bevorzugt sind auch solche Grundierungsverfahren, bei denen die Härtung der Grundierungsschicht nicht thermisch, sondern mittels UV-Bestrahlung erfolgt. Bei der Härtung mittels UV-Strahlung ist regelmäßig keine zusätzliche Erwärmung erforderlich, auch wird im Allgemeinen hierbei keine Wärme generiert. Geeignete Pulverlack-, Nasslack- und UV-härtende Grundierungssysteme sowie deren Aufbringung sind dem Fachmann hinlänglich bekannt. Je nach Oberflächenbeschaffenheit (z.B. porös oder rau) können eine oder mehrere Grundierungsschichten aufgetragen werden, um die Oberfläche zu glätten. Insbesondere mit der ersten Grundierungsschicht, wie sie vorliegend insbesondere auf Metallsubstratoberflächen zum Einsatz kommen kann, wird im Allgemeinen eine vorteilhafte Einglättung der Oberfläche erzielt. Die erste Grundierungsschicht stellt somit regelmäßig eine sogenannte Glättungsschicht dar. Mit einer Grundierungsschicht werden im Allgemeinen sämtliche Winkelbereiche erreicht, so dass auch in diesen Bereichen Oberflächenrauigkeiten ausgeglichen werden können.

Insbesondere bei metallischen Substraten hat es sich als sehr vorteilhaft erwiesen, wenn die beschichtbare Oberfläche eine polierte und/oder geschliffene, insbesondere gleitgeschliffene, und/oder dekapierte Oberfläche darstellt. Insbesondere in diesen Fällen kann auf eine erste und/oder zweite Grundierungsschicht verzichtet werden. Ferner ist es besonders zweckmäßig, die beschichtbare Oberfläche des Substrats vor der Aufbringung weiterer Schichten zu entfetten und/oder zu phosphatieren und/oder zu passivieren. Bei Substraten aus Aluminium schaltet man bevorzugt vor der Aufbringung der weiteren Schichten einen Phosphatierschritt vor.

Allerdings kann auch zusätzlich zu der Aufbringung einer Grundierungsschicht eine vorgeschaltete mechanische Glättung der Metallsubstratoberfläche, beispielsweise mittels Schleifens und/oder Polierens bzw. Gleitschleifens, vorgesehen sein.

Solche erfindungsgemäßen beschichteten Substrate sind in Bezug auf Haftung und Korrosionsschutz besonders vorteilhaft, welche ferner umfassen zwischen der beschichtbaren Oberfläche des Substrats oder dem KTL- oder ATL-beschichtetem Substrat oder dem eloxierten Substrat oder dem verchromten Substrat oder dem grundlackierten Substrat und der Metallschicht, insbesondere auf dem KTL- oder ATL-beschichtetem Substrat oder auf dem eloxierten Substrat oder auf dem verchromten Substrat oder auf dem grundlackierten Substrat, oder zwischen der beschichtbaren Oberfläche des Substrats oder dem KTL- oder ATL-beschichtetem Substrat oder dem eloxierten Substrat oder dem verchromten Substrat oder dem grundlackierten Substrat und der Grundierungsschicht, insbesondere auf dem KTL-oder ATL-beschichtetem Substrat oder auf dem eloxierten Substrat oder auf dem verchromten Substrat oder auf dem grundlackierten Substrat:
g) mindestens eine weitere Haftvermittlerschicht aus mindestens einem oxidativ trocknenden oder oxidativ getrockneten Öl.

Von besonderem Vorteil bei den erfindungsgemäßen beschichteten Substraten ist auch, dass sich gewünschte Farbeffekte auf vielfältige Weise herstellen lassen. Beispielsweise kann vorgesehen sein, dass die Haftvermittlerschicht und/oder die erste und/oder zweite Grundierungsschicht und/oder die Decklackschicht eingefärbt oder mit einer Lasur versehen vorliegen.

Bei der Metallschicht des beschichteten Substrats handelt es sich vorzugsweise um eine, insbesondere im Vakuum, aufgedampfte oder aufgesputterte Metallschicht, insbesondere Aluminiumschicht. Diese Metallschicht verfügt vorzugsweise über eine durchschnittliche, insbesondere absolute, Dicke im Bereich von 1 nm 50 nm insbesondere im Bereich von 5 nm bis 120 nm.

In einer sehr zweckmäßigen Ausgestaltung des erfindungsgemäßen beschichteten Substrats wird die Metallschicht zum Beispiel mit einer Dicke im Bereich von 60 nm bis 120 nm, vorzugsweise mit einer Dicke im Bereich von 75 nm bis 110 nm eingestellt. Bei diesen Dicken liegen die Metallschicht, insbesondere der Aluminiumschicht, deckend, d.h. im Wesentlichen nicht transparent oder transluzent auf der Oberfläche auf. Hierdurch können hochglänzende Schichten erhalten werden.

Gemäß einer weiteren vorteilhaften Ausführungsform kann die in dem erfindungsmäßen beschichteten Substrat vorliegende Metallschicht eine Dicke im Bereich von 1 nm bis 20 nm, vorzugsweise im Bereich von 1 nm bis 15 nm, insbesondere bevorzugt im Bereich von 2 nm bis 12 nm aufweisen. Es hat sich überraschend gezeigt, dass bei Verwendung sehr dünner, beispielsweise aufgedampfter oder aufgesputterter, Metallschichten, insbesondere Aluminiumschichten, ein Farbeffekt dahingehend erzielen lässt, dass die Metallschicht eine Dunkel- bzw. Schwarzfärbung zeigt. Hierdurch kann ein Endprodukt mit sehr edler Anmutung erhalten werden, ohne Einbußen beim Korrosionsschutz oder der Haftung in Kauf nehmen zu müssen. Auch ist dieser Effekt mit sehr geringer Gesamtschichtdicke zugänglich.

Auch umfasst das erfindungsgemäße beschichtete Substrat solche Ausführungsvarianten, bei denen die Metallschicht, insbesondere die Aluminiumschicht, in einer so geringen Dicke aufgetragen wird, dass die darunter liegende Schicht erkennbar bleibt, d.h. die aufgetragene dünne Metallschicht, insbesondere Aluminiumschicht, liegt hierbei in einer Ausgestaltung im Wesentlichen als transluzente Schicht auf der darunter liegenden Schicht oder dem darunter liegenden Substrat vor. Vorteilhafterweise können dann die Farbeffekte der darunter liegenden Schicht für die Gestaltung des finalen beschichteten Substrats mit verwendet werden, ohne dass auf die mit der Metallschicht einhergehenden Glanzeffekte, welche regelmäßig auf ein qualitativ hochwertiges Produkt hinweisen, verzichtet werden muss.

Demgemäß umfasst in einer besonders geeigneten Ausführungsform das erfindungsgemäße beschichtete Substrat
a) ein Substrat mit einer beschichtbaren Oberfläche,
b) mindestens eine aufgedampfte oder aufgesputterte Metallschicht, insbesondere aufgebracht mittels Physical Vapour Deposition (PVD)-Beschichtung, Aufdampfen mittels eines Elektronenstahl-Verdampfers, Aufdampfen mittels eines Widerstandsverdampfers, Indukti-onsverdampfung, ARC-Verdampfung oder Kathoden- bzw. Anodenzerstäubung (Sputter-Beschichtung), jeweils vorzugsweise im Vakuum,
c) gegebenenfalls mindestens eine Haftvermittlerschicht, gebildet aus einem oxidativ trocknenden oder oxidativ getrockneten Öl, und
d) mindestens eine, insbesondere transparente oder transluzente, Decklackschicht, wobei die Metallschicht gemäß b) vorzugsweise in einer durchschnittlichen, insbesondere absoluten,

Dicke im Bereich von 1 nm bis 20 nm, vorzugsweise im Bereich von 1 nm bis 15 nm, und besonders bevorzugt im Bereich von 2 nm bis 12 nm aufgetragen worden ist oder in einer Dicke aufgetragen worden ist, dass die darunterliegende Schicht erkennbar bleibt. Vor dem Auftragen der Metallschicht wird die zu beschichtende Oberfläche vorzugsweise getrocknet, um frei von Wasserresten zu sein.

Die Metallschicht kann mittels Aufdampf- oder Sputtertechnik erhalten werden. Für die Aufbringung der Metallschicht sei exemplarisch auf das Verfahren der Physical Vapor Deposition (PVD)-Beschichtung, das Aufdampfen mittels eines Elektronenstrahl-Verdampfers, das Aufdampfen mittels eines Widerstandsverdampfers, die Induktionsverdampfung, die ARC-Verdampfung und die Kathodenzerstäubung (Sputter-Beschichtung), jeweils vorzugsweise in einem Hochvakuum, verwiesen. Diese Verfahren sind dem Fachmann bekannt. Die Metallschicht kann beispielsweise auf dem Substrat bzw. auf dessen beschichtbarer Oberfläche, der ersten Grundierungsschicht, der zweiten Grundierungsschicht und/oder der Haftvermittlerschicht aufgebracht werden. Bevorzugt werden ein Physical Vapor Deposition-Beschichtungsverfahren (PVD) oder ein Sputterverfahren eingesetzt. Beim PVD-Verfahren kommen widerstandsbeheizte Metallwendel- oder Metallschiffchenverdampfer zum Einsatz, wobei Wolframwendeln der verschiedensten Form bevorzugt sind. Beim PVD-Verfahren wird im Allgemeinen ein Verdampfer mit Wendeln bestückt, die auf voneinander isolierten Verdampferschienen geklemmt werden können. In jede Wendel wird vorzugsweise eine genau bestimmte Menge an aufzudampfendem Metall gegeben. Nach dem Schließen und Evakuieren der PVD-Anlage kann die Verdampfung durch Einschalten der Stromversorgung, wodurch man die Verdampferschienen die Wendel zum Glühen bringt, gestartet werden. Das feste Metall beginnt zu schmelzen und benetzt die meist verdrillten Wendeln vollständig. Durch weitere Energiezufuhr wird das flüssige Metall in die Gasphase überführt, so dass es sich auf dem zu beschichtenden Substrat abscheiden kann. Über die Menge an in die Gasphase überführtem Metall und/oder die Dauer der Beschichtungsphase kann die Dicke der Metallschicht, und damit auch das Erscheinungsbild derselben gezielt eingestellt werden.

Ein weiteres bevorzugtes Verfahren zur Abscheidung der Metallschicht auf dem Substrat ist die Kathodenzerstäubung (Sputter-Verfahren). Dabei wird in einem evakuierten Behälter eine Kathode angeordnet, die mit dem negativen Pol einer Stromversorgung verbunden ist. Das Beschichtungsmaterial, das zerstäubt wird, wird unmittelbar vor der Kathode montiert und die zu beschichtenden Substrate werden gegenüber dem zu zerstäubenden Beschichtungsmaterial angeordnet. Ferner kann Argon als Prozessgas durch den Behälter geleitet werden, der schließlich noch eine Anode aufweist, die mit dem positiven Pol einer Stromversorgung verbunden ist. Nachdem der Behälter vorevakuiert worden ist, werden Kathode und Anode mit der Stromversorgung verbunden. Durch den gezielten und gesteuerten Einlass von Argon wird die mittlere freie Weglänge der Ladungsträger deutlich gesenkt. Im elektrischen Feld zwischen Kathode und Anode werden Argonatome ionisiert. Die positiv geladenen Teilchen werden mit hoher Energie zur negativ geladenen Kathode beschleunigt. Beim Auftreffen und durch Teilchenstöße im Beschichtungsmaterial wird dieses in die Dampfphase überführt, mit hoher Energie in den freien Raum beschleunigt und kondensiert dann auf den zu beschichtenden Substraten. Mit dem Sputter-Verfahren lassen sich unterschiedliche Metallschichtdicken gezielt einstellen.

Weitere in dem erfindungsgemäßen Verfahren einsetzbare Aufdampfverfahren erfolgen unter Einsatz einer Elektrodenstrahl-Verdampfung, Widerstandsverdampfung, Induktionsverdampfung und/oder einer Verdampfung mit Hilfe eines thermischen, nichtstationären Bogens (ARC-Verdampfung). Im Übrigen sind Verfahren zur Aufbringung einer Metallschicht auf ein metallisches oder nicht-metallisches Substrat dem Fachmann bekannt und sollen vorliegend, auch wenn nicht ausdrücklich genannt, mit umfasst sein.

Bevorzugt sind auch solche erfindungsgemäßen beschichteten Substrate, die ferner zwischen der ersten oder gegebenenfalls zweiten Grundierungsschicht und der Metallschicht, insbesondere auf der ersten bzw. zweiten Grundierungsschicht, umfassen:
f) mindestens eine weitere Haftvermittlerschicht aus einem oxidativ trocknenden oder oxidativ getrockneten Öl. Hierdurch werden Korrosionsschutz und Haftung nochmals erhöht.

Oxidativ trocknende Öle (auch häufig unter der Bezeichnung *"drying oil"* zu finden, z.B. unter http://en.wikipedia.org/wiki/Drying_oil) sind dem Fachmann bekannt. Hierbei handelt es sich im Sinne der Erfindung regelmäßig um bei Raumtemperatur ölige Verbindungen mit Kohlenwasserstoffketten enthaltend mindestens eine Doppelbindung und/oder mindestens eine Epoxyeinheit. Oxidativ trocknende Öle härten demgemäß in Gegenwart von Luft bzw. Sauerstoff. Ohne an eine Theorie gebunden zu sein, wird vermutet, dass der Sauerstoff in eine Kohlenstoff-Wasserstoffbindung benachbart zu der Doppelbindung oder benachbart zu einer Epoxyeinheit und/oder in eine Kohlenstoff-Sauerstoffbindung der Epoxyeinheit insertiert und es sodann zu Quervernetzungsreaktionen kommt, so dass letztendlich ein polymeres Netzwerk ausgebildet wird. Bei oxidativ trocknenden Ölen im Sinne der vorliegenden Erfindung handelt es sich insbesondere auch um die Glycerinester, insbesondere Glycerintriester von ungesättigten Fettsäuren. Auch andere ungesättigte und/oder epoxidierte Fettsäureester sind geeignet, bevorzugt aus mindestens 10, vorzugsweise mindestens 17 Kohlenstoffatomen. Auch in diesen Fettsäureestern können die Doppelbindungen demgemäß vollständig oder teilweise epoxidiert vorliegen. Hierbei sind solche oxidativ trocknenden Öle mit einer Jodzahl größer oder gleich 100, vorzugsweise größer oder gleich 120 und besonders bevorzugt größer oder gleich 130, beispielsweise größer 150, besonders geeignet. Die Jodzahl stellt die Menge in Gramm Iod dar, die formal an 100 g Fett bzw. Öl addiert werden kann. Besonders bevorzugt sind auch partiell oder vollständig epoxidierte Öle, beispielsweise epoxidiertes, insbesondere polyepoxidiertes, Sojabohnenöl. Gemäß einer besonders bevorzugten Ausgestaltung kann für die oxidativ trocknenden Öle, welche die Haftvermittlerschicht bilden oder Bestandteil hiervon sind, auf partiell oder vollständig, insbesondere vollständig, epoxidierte Fettsäuren und/oder Fettsäureester des Tallöls, z.B. epoxidiertes Tallöl, epoxidiertes Sojabohnenöl und/oder epoxidiertes Leinöl zurückgegriffen werden. Epoxidierte Tallöle sind besonders bevorzugt. Hervorgehoben seien insbesondere auch die epoxidierten Fettsäureester des Tallöls, beispielsweise die 2-Ethylhexyl-Fettsäureester des Tallöls.

Für die Haftvermittlerschicht des erfindungsgemäßen beschichteten Substrats kann insbesondere vorgesehen sein, dass das oxidativ trocknende Öl ungesättigte Fettsäuren, ungesättigte Fettsäureester, epoxidierte Fettsäuren, epoxidierte Fettsäureester, Addukte von ungesättigten Fettsäuren und/oder ungesättigten Fettsäureestern mit Maleinsäureanhydrid, Itakonsäureanhydrid oder Fumarsäureanhydrid, oder partiell oder vollständig chloriertes Maleinsäureanhydrid oder Itakonsäureanhydrid oder deren beliebige Mischungen umfasst. Besonders bevorzugt sind auch die Addukte der ungesättigten Fettsäuren und/oder ungesättigten Fettsäureester des Tallöls mit Maleinsäureanhydrid, Itakonsäureanhydrid oder Fumarsäureanhydrid, oder partiell oder vollständig chloriertes Maleinsäureanhydrid, Itakonsäureanhydrid oder Fumarsäureanhydrid oder deren beliebige Mischungen. Die vorangehend genannten bevorzugten oxidativ trocknenden Öle werden bevorzugt im Gemisch mit mindestens einem chlorierten Polyolefin, z.B. Polyvinylchlorid, für die mindestens eine Haftvermittlerschicht eingesetzt.

In einer besonders zweckmäßigen Ausgestaltung ist dabei vorgesehen, dass die Fettsäuren oder die Fettsäureester auf Linolsäure, Linolensäure, Ölsäure, Stearinsäure, Elaeostearinsäure, Elaidinsäure, Vaccensäure, Gadoleinsäure, Icosensäure, Cetoleinsäure, Erucasäure, Nervonsäure, Calendulasäure, Arachidonsäure oder Rizinolsäure basieren.

In einer besonders bevorzugten Ausgestaltung ist das oxidativ trocknende Öl ausgewählt aus der Gruppe bestehend aus Holzöl, Rizinusöl, Oiticicaöl, Fischöl, Leinöl, Safloröl, Sojaöl, Oiticicaöl, Tallöl, Baumwollsaatöl, Mohnöl, Kokosöl, Erdnussöl, Safranöl, Tungöl, Sonnenblumenöl, Menhandenöl, Perillaöl, Walnussöl, Rapssamenöle oder deren beliebige Mischungen, insbesondere Tallöl.

Für die Alkoholkomponente der Fettsäureester des oxidativ trocknenden Öls greift man vorzugsweise auf eine ein- oder mehrwertige Alkoholkomponente, insbesondere mehrwertige Alkoholkomponente, zurück, insbesondere ausgewählt aus der Gruppe bestehend aus Ethylenglykol, Diethylenglykol, Glycerin, Pentaerythrit, Trimethylolethan, Trimethylolpropan, Neopentylglykol, Propylenglykol, Sorbitol, Dipropylenglykol, 1,6-Hexandiol, 1,3-Butylenglykol, Dipentaerythrit, Triethylenglykol oder deren beliebige Mischungen.

Ferner wurde überraschend gefunden, dass sich solche erfindungsgemäßen beschichteten Substrate durch gute Haftung und guten Korrosionsschutz auszeichnen, bei denen die mindestens eine Haftvermittlerschicht ferner aus mindestens einem chlorierten Polyolefin, z.B. Polyvinylchlorid, gebildet ist oder dieses enthält (auch unter der Abkürzung CPO bekannt). Der Chlorierungsgrad geeigneter chlorierter Polyolefine liegt üblicherweise im Bereich von 10 bis 40 Gew.-%, bezogen auf chloriertes Polymer. Dabei kann das chlorierte Polyolefin in geeigneten Lösungsmitteln gelöst und entweder dem Haftvermittlerbeschichtungsmaterial zugegeben oder in Form eines Primers auf der Oberfläche aufgebracht werden. Als chlorierte Polyolefine (CPO) können die aus dem Stand der Technik bekannten und üblicherweise verwendeten chlorierten Polyolefine, wie chloriertes Polyethylen, chloriertes Polypropylen oder chloriertes Ethylen/Propylen-Copolymer, oder Gemische davon verwendet werden. Vorzugsweise hat das chlorierte Polyolefin einen Chlorierungsgrad von 15 bis 35 Gew%.

Als vorteilhaft in Bezug auf Haftvermögen und Korrosionsschutz hat sich unter anderem auch erwiesen, dass nach dem Aufbringen ersten und/oder zweiten Grundierungsschicht oder der Metallschicht die beschichtete Oberfläche des Substrats einem Spülschritt mit, insbesondere vollentsalztem, Wasser unterzogen wird. Hieran schließt sich vorzugsweise jeweils mindestens ein Trocknungsschritt zum Trocknen der Oberfläche an. Der Trocknungsschritt kann z.B. bei Temperaturen im Bereich von 120 bis 180°C, beispielsweise bei etwa 140°C, durchgeführt werden.

Gemäß einer weiteren Ausführungsform kann das beschichtete Substrat ferner mindestens eine, insbesondere transparente, Deckschicht umfassen. Im Allgemeinen können für die Deckschicht auch wasserverdünnbare Beschichtungszusammensetzungen verwendet werden, beispielsweise enthaltend oder aus Polyester-, Poylacrylat-, Polyurethan- oder Aminoplastharzen. Die Deck- bzw. Schutzschichtlack kann z.B. ein Klarlack oder ein transparentes Pulver sein und wird vorzugsweise über ein Nasslackverfahren bzw. ein Pulverbeschichtungsverfahren aufgetragen. Auch können UV-härtende Deckschichten als Abschlussschicht bei dem erfindungsgemäßen beschichteten Substrat vorliegen. Ferner sieht die Erfindung vor, dass die Deckschicht mindestens einen Farbstoff oder ein Pigment enthalten kann. Bei der Deckschicht bzw. dem Decklack kann es sich zum Beispiel um ein-, zwei- oder mehrkomponentige Lacke handeln. Hierbei sind Klarlacke bevorzugt. Bei diesen Klarlacken kann es sich z.B. um chemisch vernetzende zweikomponentige, um einkomponentige wärmehärtende oder um UV-härtende Lacke handeln. Die Deck- bzw. Klarlackschicht kann in einem separaten Schritt im Anschluss an die Herstellung bzw. Aushärtung, d.h. oxidative Trocknung der Haftvermittlerschicht oder auch gemeinsam mit dieser ausgehärtet werden. Die Deckschicht kann mindestens einen Farbstoff oder ein Pigment enthalten.

Zur Färbung des Substrats kann ferner als Deckschicht oder zusätzlich zur vorangehend beschriebenen Deckschicht insbesondere auch auf geeignete, dem Fachmann bekannte Lasuren zurückgegriffen werden. Hiermit lassen sich z.B. Messing-, Titan- und Goldtöne sowie individuelle Farbtöne wie rot, blau, gelb, grün, etc. und sämtliche Eloxalfarben ohne weiteres einstellen.

Von weiterem Vorteil ist zudem, dass sich mit dem erfindungsgemäßen beschichteten Substrat insbesondere auch dadurch zusätzliche Spielräume bei der Farbgestaltung ergeben, dass man die Farben bzw. Farbeffekte von Deckschicht, Haftvermittlerschicht(en), Metallschicht und Grundierung aufeinander abstimmen kann. Beispielsweise kann man eine dunkelfarbige oder weiße Grundierung, eine transluzente Metallschicht und eine transparente Deckschicht miteinander kombinieren. Durch die Kombination von Farbeffekten von mindestens zwei Schichten lässt sich z.B. mattierter Chromglanz erhalten, ohne auf die Verwendung von Chrom angewiesen zu sein.

Weitere Farbeffekte können auch dadurch erzielt werden, dass man in der Deckschicht Effektpigmente wie Perlglanzpigmente, LCP-Pigmente (liquid crystal polymer) oder OV-Pigmente (optical variable) verwendet. Übliche Perlglanzpigmente umfassen zum Beispiel metalloxidbeschichtete Metallpigmente, zum Beispiel titandioxidbeschichtetes, eisenoxidbeschichtetes oder mischoxidbeschichtetes Aluminium. Unter Perlglanzpigmente fallen ebenfalls beschichtete Glimmer. Bei OV-Pigmenten handelt es sich im Allgemeinen um Pigmentplättchen mit einer speziellen mehrschichtigen Dünnschichtinterferenzstruktur, wobei die Schichten sich aus einer hochreflektierenden Metallschicht wie Aluminium oder Chrom, einer transparenten dielektrischen Schicht aus Titandioxid oder Siliciumdioxid und einer semitransparenten Metallschicht aus beispielsweise Nickel oder Aluminium zusammensetzen. Des Weiteren können in der Beschichtungszusammensetzung für die Deckschicht auch Anteile an farbgebenden organischen und/oder anorganischen Pigmenten vor-banden sein. In der Deckschicht können darüber hinaus herkömmliche lacktechnische Additive vorliegen wie die Rheologie beeinflussende Mittel, Verdicker, Antiabsetzmittel, Verlaufsmittel, Lichtschutzmittel, Antischaummittel, Netzmittel oder Mischungen dieser Komponenten. Die Deckschicht verfügt in der Regel über eine Dicke im Bereich von 20 bis 30 µm.

Bei den erfindungsgemäßen beschichteten Substraten kann es sich z.B. um Zubehörteile für den Automobilbau, Motorradbau, Fahrradbau oder Schiffbau, Felgen, insbesondere Leichtmetallfelgen, Räder, insbesondere Leichtmetallräder oder Bestandteile hiervon, um Sanitäreinrichtungsgegenstände, insbesondere Armaturen, oder Bestandteile hiervon, Karosserieinnen- oder Außenbauteile oder Bestandteile hiervon, Griffe oder Griffkomponenten, insbesondere Türgriffe oder Bestandteile hiervon, Profile oder Rahmen, insbesondere Fensterrahmen oder Bestandteile hiervon, Beschlagsysteme oder Bestandteile hiervon, Schilder und Türschilder, Schmuckgegenstände, Bauteile für Gebäude, Heizkörper, Rohre oder Bestandteile hiervon, Bauteile für Aufzüge oder Bestandteile hiervon, Bauteile von Elektronikkomponenten oder -geräte oder Bestandteile hiervon, oder um Bauteile für Kommunikationskomponenten oder -geräte, insbesondere Handys, hiervon handeln. In einer bevorzugten Ausführungsform stellen die erfindungsgemäßen beschichteten Substrate eine Felge, einen Sanitärgegenstand, insbesondere Armatur, einen Griff oder eine Griffkomponente, ein Profil oder einen Rahmen, ein Beschlagsystem oder einen Bestandteil hiervon, Schilder, ein Möbelbauteil oder ein Zubehörteil für den Automobil-, Motorrad-, Fahrrad- oder Flugzeugbau dar.

Die Beschichtungsdicken bei den erfindungsgemäßen beschichteten Substraten können in weiten Bereichen variiert werden und liegen gemäß einer Ausführungsform z.B. im Bereich von 5 bis 50 µm oder im Bereich von 10 bis 35 µm.

Besonders geeignete Ausführungsvarianten der erfindungsgemäßen beschichteten Substrate verfügen z.B. über die folgende Schichtenfolge:
- Substrat/KTL- (oder ATL)-Beschichtung/Haftvermittlerschicht/Grundierung (erste und gegebenenfalls zweite Grundierungsschicht)/Metallschicht, insbesondere Aluminium-schicht/Haftvermittlerschicht/Deckschicht oder
- Substrat/KTL- (oder ATL)-Beschichtung/Grundierung/Metallschicht, insbesondere Aluminiumschicht/Haftvermittlerschicht/Deckschicht oder
- Substrat/Eloxierschicht/Haftvermittlerschicht/Grundierung/Metallschicht, insbesondere Aluminiumschicht/Haftvermittlerschicht/Deckschicht oder
- Substrat/Chromschicht/Haftvermittlerschicht/Grundierung/Metallschicht, insbesondere Aluminiumschicht/Haftvermittlerschicht/Deckschicht oder
- Substrat/Haftvermittlerschicht/Grundierung/Metallschicht, insbesondere Aluminiumschicht/Haftvermittlerschicht/Deckschicht oder
- Substrat/Haftvermittlerschicht/Grundierung (erste und gegebenenfalls zweite Grundierungsschicht)/Metallschicht, insbesondere Aluminiumschicht/ Haftvermittlerschicht/Deckschicht oder
- Substrat/Grundierung (erste und gegebenenfalls zweite Grundierungsschicht)/ Metallschicht, insbesondere Aluminiumschicht/Haftvermittlerschicht/Deckschicht.

Die vorangehend genannten Schichten entsprechen den in dieser Anmeldung offenbarten erfindungsgemäßen Definitionen.

Der Erfindung liegt die überraschende Erkenntnis zugrunde, dass mit dem erfindungsgemäßen beschichteten Substrat eine metallische Schutzbeschichtung bereitgestellt wird, die eine ausgezeichnete Korrosionsbeständigkeit bei sehr ansprechender und zudem einstellbarer Optik liefert. Die erfindungsgemäßen beschichteten Substrate zeichnen sich zudem durch eine ausgeprägte Haftung aus. Demgemäß zeigen die erfindungsgemäßen beschichteten Substrate selbst dann überragende Korrosionsbeständigkeiten, wenn die Oberflächen mechanische Beschädigungen erfahren haben, beispielsweise mittels Steinschlag oder durch Anritzen.

Die in der voranstehenden Beschreibung und den Ansprüchen offenbarten Merkmale der Erfindung können sowohl einzeln als auch in jeder beliebigen Kombination für die Verwirklichung der Erfindung vorteilhaft sein.

## Patentansprüche

1. Beschichtetes Substrat, umfassend
a) ein Substrat mit einer beschichtbaren Oberfläche,
b) mindestens eine Metallschicht aufgebracht mittels Physical Vapour Deposition (PVD)-Beschichtung, Aufdampfen mittels eines Elektronenstahl-Verdampfers, Aufdampfen mittels eines Widerstandsverdampfers, Induktionsverdampfung, ARC-Verdampfung oder Kathoden- bzw. Anodenzerstäubung (Sputter-Beschichtung),
c) mindestens eine Haftvermittlerschicht, gebildet aus einem oxidativ trocknenden oder oxidativ getrockneten Öl, und
d) mindestens eine, insbesondere transparente oder transluzente, Deckschicht.

2. Beschichtetes Substrat nach Anspruch 1, ferner umfassend, insbesondere unmittelbar auf der beschichtbaren Oberfläche des Substrats:
e) mindestens eine erste und gegebenenfalls hierauf aufliegend mindestens eine zweite Grundierungsschicht.

3. Beschichtetes Substrat nach einem der vorangehenden Ansprüche, **dadurch gekennzeichnet, dass** das Substrat ein KTL- oder ein ATL-beschichtetes Substrat, ein eloxiertes Substrat, ein, insbesondere galvanisch, verchromtes Substrat oder ein grundlackiertes Substrat darstellt.

4. Beschichtetes Substrat nach Anspruch 2 oder 3, ferner umfassend zwischen der ersten oder gegebenenfalls zweiten Grundierungsschicht und der Metallschicht, insbesondere auf der ersten bzw. zweiten Grundierungsschicht:
t) mindestens eine weitere Haftvermittlerschicht aus einem oxidativ trocknenden oder oxidativ getrockneten Öl.

5. Beschichtetes Substrat nach einem der vorangehenden Ansprüche, ferner umfassend zwischen der beschichtbaren Oberfläche des Substrats oder dem KTL- oder ATL-beschichtetem Substrat oder dem eloxierten Substrat oder dem verchromten Substrat oder dem grundlackierten Substrat und der Metallschicht, insbesondere auf dem KTL-oder ATL-beschichtetem Substrat oder dem eloxierten Substrat oder dem verchromten Substrat oder dem grundlackierten Substrat, oder zwischen der beschichtbaren Ober-fläche des Substrats oder dem KTL- oder ATL-beschichtetem Substrat oder dem eloxierten Substrat oder dem verchromten Substrat oder dem grundlackierten Substrat und der Grundierungsschicht, insbesondere auf dem KTL- oder ATL-beschichtetem Substrat oder dem eloxierten Substrat oder dem verchromten Substrat oder dem grundlackierten Substrat:
g) mindestens eine weitere Haftvermittlerschicht aus mindestens einem oxidativ trocknenden oder oxidativ getrockneten Öl.

6. Beschichtetes Substrat nach einem der vorangehenden Ansprüche, **dadurch gekennzeichnet, dass** die Haftvermittlerschicht und/oder die erste und/oder zweite Grundierungsschicht und/oder die Deckschicht eingefärbt oder mit einer Lasur versehen vorliegen.

7. Beschichtetes Substrat nach einem der vorangehenden Ansprüche, **dadurch gekennzeichnet, dass** die beschichtbare Oberfläche eine polierte und/oder geschliffene, insbesondere gleitgeschliffene, und/oder dekapierte Oberfläche und/oder dass die beschichtbare Oberfläche des Substrats eine entfettete und/oder phosphatierte und/oder passivierte Oberfläche darstellt.

8. Beschichtetes Substrat nach einem der vorangehenden Ansprüche, **dadurch gekennzeichnet, dass** die Metallschicht eine, insbesondere im Vakuum aufgedampfte oder gesputterte, Metallschicht, insbesondere Aluminiumschicht, darstellt und/oder umfasst.

9. Beschichtetes Substrat nach einem der vorangehenden Ansprüche, **dadurch gekennzeichnet, dass** die Metallschicht eine durchschnittliche, insbesondere absolute, Dicke im Bereich von 1 nm bis 150 nm, insbesondere im Bereich von 5 nm bis 120 nm, aufweist.

10. Beschichtetes Substrat nach einem der vorangehenden Ansprüche, **dadurch gekennzeichnet, dass** die Metallschicht, insbesondere Aluminiumschicht, in einer Dicke aufgetragen, insbesondere aufgedampft oder aufgesputtert, wird, dass die darunterliegende Schicht erkennbar bleibt.

11. Beschichtetes Substrat nach einem der vorangehenden Ansprüche, **dadurch gekennzeichnet, dass** die Metallschicht in einer Dicke im Bereich von 1 nm bis 20 nm, vorzugsweise im Bereich von 1 nm bis 15 nm, und besonders bevorzugt im Bereich von 2 nm bis 12 nm vorliegt.

12. Beschichtetes Substrat nach einem der vorangehenden Ansprüche, **dadurch gekennzeichnet, dass** das oxidativ trocknende Öl ungesättigte Fettsäuren, ungesättigte Fettsäureester, epoxidierte Fettsäuren, epoxidierte Fettsäureester, Addukte von ungesättigten Fettsäuren und/oder ungesättigten Fettsäureester mit Maleinsäureanhydrid, Itakonsäureanhydrid oder Fumarsäureanhydrid, und/oder einem partiell oder vollständig chlorierten Maleinsäureanhydrid und/oder Itakonsäureanhydrid oder deren beliebige Mischungen umfasst.

13. Beschichtetes Substrat nach Anspruch 12, **dadurch gekennzeichnet, dass** die Fettsäure oder der Fettsäureester auf Linolsäure, Linolensäure, Ölsäure, Stearinsäure, Elaeostearinsäure, Elaidinsäure, Vaccensäure, Gadoleinsäure, Icosensäure, Cetoleinsäure, Erucasäure, Nervonsäure, Calendulasäure, Arachidonsäure oder Rizinolsäure basieren und/oder dassdas oxidativ trockenen Öl ausgewählt ist aus der Gruppe bestehend aus Holzöl, Rizinusöl, Oiticicaöl, Fischöl, Leinöl, Safloröl, Sojaöl, Oiticicaöl, Tallöl, Baumwollsaatöl, Mohnöl, Kokosöl, Erdnussöl, Safranöl, Tungöl, Sonnenblumenöl, Menhandenöl, Perillaöl, Walnussöl, Rapssamenöle, Perillaöl oder deren beliebige Mischungen, insbesondere Tallöl.

14. Beschichtetes Substrat nach Anspruch 12 oder 13, **dadurch gekennzeichnet, dass** die Alkoholkomponente des Fettsäureester des oxidativ trockenden Öls eine ein- oder mehrwertige Alkoholkomponente, insbesondere mehrwertige Alkoholkomponente, darstellt, insbesondere ausgewählt aus der Gruppe bestehend aus Ethylenglykol, Diethylenglykol, Glycerin, Pentaerythrit, Trimethylolethan, Trimethylolpropan, Neopentylglykol, Propylenglykol, Sorbitol, Dipropylenglykol, 1,6-Hexandiol, 1,3-Butylenglykol, Dipentaerythrit, Triethylenglykol oder deren beliebige Mischungen.

15. Beschichtetes Substrat nach einem der vorangehenden Ansprüche, **dadurch gekennzeichnet, dass** das oxidativ trocknende Öl der mindestens einen Haftvermittlerschicht partiell oder vollständig, insbesondere vollständig, epoxidierte Fettsäuren und/oder Fettsäureester des Tallöls, Sojabohnenöls und/oder Leinöls, insbesondere des Tallöls, z.B. epoxidiertes Tallöl, epoxidiertes Sojabohnenöl und/oder epoxidiertes Leinöl, insbesondere epoxidiertes Tallöl, oder Addukte der ungesättigten Fettsäuren und/oder ungesättigten Fettsäureester des Tallöls, Sojabohnenöls und/oder Leinöls mit Maleinsäureanhydrid, Itakonsäureanhydrid oder Fumarsäureanhydrid, oder mit partiell oder vollständig chloriertem Maleinsäureanhydrid, Itakonsäureanhydrid oder Fumarsäureanhydrid oder beliebige Mischungen der genannten Verbindungen umfasst.

16. Beschichtetes Substrat nach einem der vorangehenden Ansprüche, **dadurch gekennzeichnet, dass** die mindestens eine Haftvermittlerschicht ferner aus mindestens einem chlorierten Polyolefin (CPO) gebildet ist oder dieses enthält.

17. Beschichtetes Substrat nach einem der vorangehenden Ansprüche, **dadurch gekennzeichnet, dass** das Substrat metallische Substrate und nicht metallische Substrate, insbesondere gebildet aus Glas, Keramik, Karbonmaterialien, Verbundfasermaterialien oder Kunststoff, umfasst.

18. Beschichtetes Substrat, insbesondere nach einem der vorangehenden Ansprüche, umfassend
a) ein Substrat mit einer beschichtbaren Oberfläche,
b) mindestens eine Metallschicht aufgebracht mittels Physical Vapour Deposition (PVD)-Beschichtung, Aufdampfen mittels eines Elektronenstahl-Verdampfers, Aufdampfen mittels eines Widerstandsverdampfers, Induktionsverdampfung, ARC-Verdampfung oder Kathoden- bzw. Anodenzerstäubung (Sputter-Beschichtung), jeweils vorzugsweise im Vakuum,
c) gegebenenfalls mindestens eine Haftvermittlerschicht, gebildet aus einem oxidativ trocknenden oder oxidativ getrockneten Öl, und
d) mindestens eine, insbesondere transparente oder transluzente, Deckschicht, wobei die Metallschicht gemäß b) vorzugsweise in einer durchschnittlichen, insbesondere absoluten, Dicke im Bereich von 1 nm bis 20 nm, vorzugsweise im Bereich von 1 nm bis 15 nm, und besonders bevorzugt im Bereich von 2 nm bis 12 nm aufgetragen worden ist oder in einer Dicke aufgetragen worden ist, dass die darunterliegende Schicht erkennbar bleibt.

19. Beschichtetes Substrat nach einem der vorangehenden Ansprüche, **dadurch gekennzeichnet, dass** dieses eine Felge, einen Sanitärgegenstand, insbesondere Armatur, einen Griff oder eine Griffkomponente, ein Profil oder einen Rahmen, ein Beschlagsystem oder einen Bestandteil hiervon, Schilder, ein Möbelbautell oder ein Zubehörteil für den Automobil-, Motorrad-, Fahrrad- oder Flugzeugbau darstellt.
